# DEMANDE DE BREVET EUROPEEN

(11) **EP 4 105 990 A1**
(43) Date de publication de la demande: **21.12.2022**
(21) Numéro de dépôt: 22177759.2
(22) Date de dépôt: 08.06.2022
(51) Int. Cl.: H01L 27/06, H01L 27/02, H01L 27/07, H01L 27/085, H01L 21/8252, H01L 29/778, H01L 29/20, H01L 29/423, H01L 29/872

(54) **CIRCUIT DE COMMUTATION COMPACT DOTÉ DE TRANSISTORS À HÉTÉROJONCTION**

(30) Priorité: 14.06.2021 FR 2106222
(71) Demandeur: Commissariat à l'énergie atomique et aux énergies alternatives, 75015 Paris (FR)
(72) Inventeur: ESCOFFIER, René, 38054 GRENOBLE CEDEX 09 (FR)
(74) Mandataire: Brevalex

(57) **Abrégé**

Circuit de commutation formant interrupteur bidirectionnel entre un premier nœud (NA) et un deuxième nœud (NB) et reposant sur un substrat, le circuit comprenant°:
- une première branche (47A) avec une première diode (41) en série avec un premier transistor (T₁) à hétérojonction à effet de champ,
- une deuxième branche (47B) avec un deuxième transistor à hétérojonction à effet de champ (T₂) en série avec une deuxième diode (42), la première branche (47A) et la deuxième branche (47B) étant montées en parallèle l'une de l'autre et de sorte que la première diode (41) et la deuxième diode (42) sont agencées en antiparallèle ou en anti-série l'une par rapport à l'autre, le premier transistor (T₁), le deuxième transistor (T₂) étant pourvus chacun d'une grille de commande (G1, G2) en regard d'une bande d'hétérojonction formant une zone active (40) dans laquelle un gaz d'électrons est apte à être formé, la première diode (41) étant une diode Schottky avec une électrode métallique (43) en contact avec la bande d'hétérojonction, la deuxième diode (42) étant une diode Schottky avec une électrode métallique (45) en contact avec la bande d'hétérojonction, la première diode (41), le premier transistor (T₁), la deuxième diode (42), le deuxième transistor (T₂) partageant la même zone active (figure 5).

## Description

### DOMAINE TECHNIQUE

La présente demande concerne le domaine des circuits de commutation, en particulier de commutation de puissance destinés à réaliser une commutation en tension et/ou en courant, et comportant au moins un fonctionnement bidirectionnel en tension ou en courant ou en tension et en courant.

Elle a trait en particulier à la réalisation d'un circuit de commutation amélioré pouvant fonctionner comme un interrupteur 4-quadrants et susceptible d'être utilisé notamment pour une conversion d'énergie, en particulier dans une gamme comprise entre plusieurs milliwatts et plusieurs dizaines de watts.

### ÉTAT DE LA TECHNIQUE ANTÉRIEURE

Pour réaliser une fonction d'interrupteur bidirectionnel également appelé 4-quadrants divers agencements existent.

Il est connu notamment de prévoir une branche de circuit dans laquelle on associe :
- un transistor FET (pour « Field-Effect Transistor, autrement dit « transistor à effet de champ ») et une diode connectés en série, ou bien,
- un transistor IGBT (pour « Insulated Gate Bipolar Transistor » autrement dit transistor bipolaire à grille isolée) et une diode connectés en série ou bien un thyristor GTO (de l'anglais « Gate Turn-Off Thyristor » autrement dit à extinction par la gâchette) et une diode connectés en série, voire
- un thyristor IGCT (pour « Integrated Gate Commutated Thyristor » autrement dit « thyristor à commutation de grille intégré »).

Une telle branche permet de réaliser une fonction d'interrupteur bidirectionnel en tension et unidirectionnel en courant. Pour réaliser la fonction d'interrupteur bidirectionnel en courant on associe donc deux telles branches en anti-parallèle.

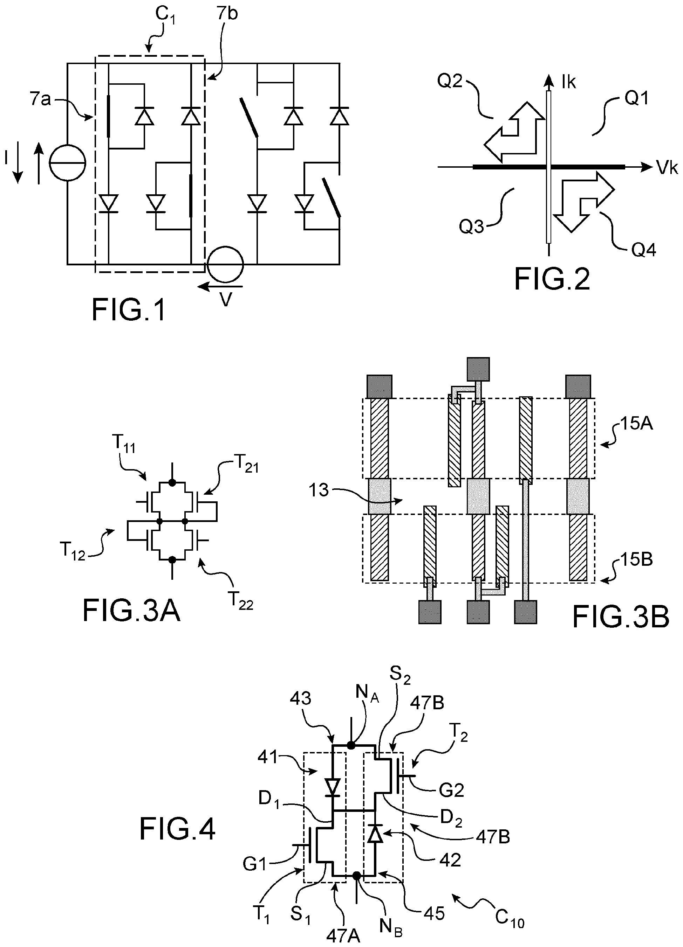

Ainsi une cellule C₁ de base d'interrupteur bidirectionnel est illustrée sur la figure 1 et est ici formée de deux branches 7a, 7b agencées tête-bêche et chacune dotée d'un élément interrupteur interdisant le passage du courant dans certaines conditions (auto-blocage ou blocage commandé) et permettant ce passage le reste du temps (auto-amorçage et amorçage commandé).

On obtient donc un composant bidirectionnel en tension et en courant, dont une caractéristique courant-tension idéale est représentée de manière schématique sur la figure 2, dans un repère orthogonal définissant quatre quadrants Q1 (tension positive courant positif), Q2 (tension négative courant positif), Q3 (tension négative courant négatif), Q4 (tension positive courant négatif). Pour ce composant que l'on appelle également interrupteur 4-quadrants, l'auto-commutation se produit ici dans les quadrants Q2 et Q4, avec respectivement d'une part un blocage spontané au zéro de courant et un amorçage spontané au zéro de tension, et d'autre part un blocage spontané au zéro de courant et un amorçage spontané au zéro de tension.

Le document FR3028666A1 prévoit une structure d'interrupteur bidirectionnel particulière formée de 4 transistors à hétéro-jonction à effet de champ (ou HEMT pour « High-Electron-Mobility Transistor », i.e. « transistor à haute mobilité d'électrons ») répartis en deux branches, deux transistors T₁₂, T₂₁ étant montés en diode, les deux autres T₁₁, T₂₂ suivant un montage conventionnel.

Une telle structure s'adapte tout particulièrement à des applications de puissance, puisqu'elle est formée de transistors présentant une tension de claquage élevée, avec une résistance de conduction réduite et une densité de courant potentiellement élevée. Comme on peut le voir sur la figure 3B, la structure est formée dans deux zones actives 15A, 15B distinctes et espacées l'une de l'autre, chacune des zones actives étant formée d'un empilement de couches semi-conductrices respectivement à base de GaN et à base d'AIGaN formant une hétéro-jonction. Chaque branche de la structure de commutation est ainsi formée par une zone active 15A, 15B dans laquelle un gaz 2D d'électrons est produit. Les deux zones actives sont ici typiquement séparées l'une de l'autre par le biais d'une zone isolante 13 par exemple sous forme d'une tranchée.

Un inconvénient d'une telle structure est son encombrement, cette dernière occupant une surface totale égale à celle de deux zones actives individuelles à laquelle on ajoute la zone d'isolation entre les deux zones actives.

Par ailleurs, le fait d'utiliser des transistors montés en diode implique une tension de déclenchement Vf égale à la tension de seuil Vth du transistor, ce qui entraine des pertes à l'état passant.

Il se pose donc le problème de trouver une nouvelle structure de commutation améliorée vis-à-vis d'inconvénients mentionnés ci-dessus.

### EXPOSÉ DE L'INVENTION

Selon un aspect la présente invention concerne un circuit de commutation formant interrupteur bidirectionnel entre un premier nœud et un deuxième nœud et reposant sur un substrat, le substrat étant recouvert d'une bande d'hétérojonction formant une zone active dans laquelle un gaz d'électrons est apte à être formé, ledit circuit étant doté :
- d'une première branche formée, entre une extrémité reliée au premier nœud et une autre extrémité reliée au deuxième nœud : d'une première diode en série avec un premier transistor à hétérojonction à effet de champ,
- d'une deuxième branche formée, entre une extrémité reliée au premier nœud et une autre extrémité reliée au deuxième nœud : d'un deuxième transistor à hétérojonction à effet de champ en série avec une deuxième diode, la première branche et la deuxième branche étant montées en parallèle l'une de l'autre et de sorte que la première diode et la deuxième diode sont agencées en anti-série ou antiparallèle l'une par rapport à l'autre, le premier transistor, le deuxième transistor étant pourvus chacun d'une grille de commande en regard d'une bande d'hétérojonction formant une zone active dans laquelle un gaz d'électrons est apte à être formé, la première diode étant une diode Schottky pourvue d'une électrode métallique appelée « première électrode métallique » en contact avec ladite bande d'hétérojonction, la deuxième diode étant une diode Schottky pourvue d'une électrode métallique appelée « deuxième électrode métallique » en contact avec ladite bande d'hétérojonction, la première diode, le premier transistor, la deuxième diode, le deuxième transistor partageant ladite même zone active.

On associe ici avantageusement une diode et un transistor en série monté en anti-série ou en antiparallèle et on en utilise des diodes Schottky dont la zone semi-conductrice est partagée avec celle du transistor.

Avantageusement le drain du premier transistor et le drain du deuxième transistor peuvent être connectés l'un à l'autre. Dans ce cas les transistors sont en anti-série.

Ainsi la première diode, le premier transistor, la deuxième diode, le deuxième transistor sont agencés respectivement de sorte que lorsque la première branche est rendue passante un premier courant est apte à circuler dans ladite bande entre la première électrode métallique et une première électrode de conduction du premier transistor, lorsque la deuxième branche est rendue passante un deuxième courant est apte à circuler dans ladite même bande d'hétérojonction entre la deuxième électrode métallique et une première électrode de conduction du deuxième transistor.

Par rapport à un circuit tel que mis en œuvre suivant l'art antérieur, on limite les pertes à l'état passant et on n'utilise qu'une seule zone active pour réaliser les deux branches de commutation. Cela permet ainsi de gagner en compacité selon un facteur deux sur la surface occupée sur un substrat sur lequel repose le circuit. Cela représente un avantage en termes de cout de fabrication sur puce et de mise en boitier.

Selon une première possibilité d'agencement, le circuit de commutation comporte, en regard de la zone active dans cet ordre, et dans une première direction x parallèle à un plan principal du substrat : une première électrode de conduction du premier transistor, une deuxième électrode de conduction du premier transistor, ladite première électrode métallique appartenant à la première diode, une première électrode de conduction du deuxième transistor, une deuxième électrode de conduction du deuxième transistor, la deuxième électrode métallique appartenant à la deuxième diode.

Avantageusement, la première électrode métallique et la deuxième électrode métallique s'étendent parallèlement à une deuxième direction, orthogonale à la première direction, et ont des longueurs respectives mesurées parallèlement à la deuxième direction supérieures ou égales à une largeur de la zone active mesurée dans la deuxième direction.

Selon une deuxième possibilité d'agencement, le circuit de commutation peut comporter, en regard de la zone active dans une première direction parallèle à un plan principal du substrat : une première électrode de conduction du deuxième transistor, la grille de commande du deuxième transistor, la première électrode métallique, la deuxième électrode métallique, la grille de commande du premier transistor, une première électrode de conduction du premier transistor, la première électrode métallique et la deuxième électrode métallique étant agencées entre la grille de commande du deuxième transistor et la grille de commande du premier transistor.

Avantageusement, le premier transistor et le deuxième transistor comportent une deuxième électrode de conduction, la deuxième électrode de conduction étant commune au premier transistor et au deuxième transistor, ladite deuxième électrode de conduction commune étant agencée entre la première électrode métallique et la deuxième électrode métallique.

De manière avantageuse, la première électrode métallique et la deuxième électrode métallique s'étendent parallèlement à une deuxième direction, orthogonale à la première direction, et ont des longueurs respectives mesurées parallèlement à la deuxième direction inférieures à une largeur de la zone active mesurée dans la deuxième direction, de sorte que dans la deuxième direction une portion de la zone active située dans le prolongement de la première électrode métallique n'est pas recouverte par la première électrode métallique et de sorte que dans la deuxième direction une autre portion de la zone active située dans le prolongement de la deuxième électrode métallique n'est pas recouverte par la deuxième électrode métallique.

Selon un mode de réalisation particulier, le premier transistor et/ou le deuxième transistor a une première électrode de conduction typiquement une électrode de source et une deuxième électrode de conduction typiquement une électrode de drain formées chacune d'un contact ohmique.

Selon une troisième possibilité d'agencement, le circuit de commutation peut comporter, en regard de la zone active dans une première direction x parallèle à un plan principal du substrat une première région et une deuxième région juxtaposée à la première région : la première branche et la deuxième branche, réparties respectivement dans la première région et dans la deuxième région,
- la première branche comportant, sur un premier axe parallèle à la deuxième direction et réalisant un angle non-nul avec la première direction et en particulier orthogonal à la première direction : la première électrode métallique, la grille de commande du premier transistor, une première électrode de conduction du premier transistor,
- la deuxième branche comportant sur un deuxième axe parallèle ou sensiblement parallèle au premier axe : une première électrode de conduction du deuxième transistor, la grille de commande du deuxième transistor, la deuxième électrode métallique, la première électrode métallique et la deuxième métallique étant réparties sur un troisième axe donné réalisant un angle non-nul avec le premier axe et le deuxième axe, la grille de commande du premier transistor et la grille de commande du deuxième transistor, étant réparties sur un quatrième axe réalisant un angle non-nul avec le premier axe (A1), le deuxième axe (A2), et ledit troisième axe.

Par « sensiblement parallèle on entend ici qui réalisent l'un par rapport à l'autre un angle inférieur à 10°.

Avantageusement, le premier transistor et/ou le deuxième transistor comporte une grille de commande qui entoure partiellement la première électrode de conduction.

Selon un mode de réalisation particulier, le premier transistor et le deuxième transistor comportent chacun une première électrode de conduction comprenant une zone métallique en contact avec ladite bande d'hétérojonction, et dans lequel le premier transistor et le deuxième transistor comportent une deuxième électrode de conduction constituée par une zone de ladite bande d'hétérojonction.

Avantageusement, la bande d'hétérojonction est entourée d'une structure configurée pour empêcher la diffusion du gaz 2D autour de ladite bande d'hétérojonction telle qu'une zone isolante ou une zone dopée, en particulier dopée à l'Argon.

Selon un mode de réalisation avantageux, le premier transistor et le deuxième transistor sont des transistors à haute mobilité électronique HEMT, ladite bande d'hétérojonction étant formée d'une première couche semi-conductrice en particulier à base d'AIGaN empilée sur une deuxième couche semi-conductrice, en particulier en GaN.

La présente invention concerne également un dispositif électronique de puissance comprenant un convertisseur, en particulier AC/DC ou DC/AC ou AC/AC, doté d'une pluralité de cellules de commutation, chaque cellule de commutation étant pourvue d'un circuit de commutation tel que défini plus haut.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
La figure 1 sert à illustrer un schéma électrique d'un circuit intégré de commutation dont les cellules forment un interrupteur bidirectionnel ;
La figure 2 sert à illustrer une caractéristique courant-tension idéale d'un interrupteur 4-quadrants ;
Les figures 3A, 3B servent à illustrer un circuit intégré de commutation suivant l'art antérieur formant un interrupteur 4-quadrants adapté à des applications de puissance et réalisé à partir de quatre transistors HEMT dont deux sont montés en diode pour former deux branches de circuits distinctes réalisées dans deux zones actives distinctes et isolées l'une de l'autre ;
La figure 4 sert à illustrer un circuit de commutation mise en œuvre suivant la présente invention à transistors à hétérojonction et à diodes Schottky pour former deux branches de commutation cette fois dans une seule zone active ;
La figure 5 sert à illustrer une vue de dessus d'un premier mode de réalisation d'une structure de circuit de commutation suivant l'invention ;
La figure 6 sert à illustrer une vue en coupe partielle du premier mode de réalisation de la structure de circuit de commutation suivant l'invention ;
Les figures 7A, 7B, 7C, 7D, 7E, 7F, 7G, 7H, 7I sont des vues en coupe partielle d'une portion du circuit intégré de commutation à différentes étapes d'un exemple de procédé de fabrication ;
La figure 8 sert à illustrer une structure de circuit de commutation mise en œuvre selon un deuxième mode de réalisation de la présente invention ;
La figure 9 sert à illustrer une vue en coupe partielle de la structure de circuit de commutation suivant le deuxième mode de réalisation ;
La figure 10 sert à illustrer une structure de circuit de commutation mise en œuvre selon un troisième mode de réalisation de la présente invention ;
La figure 11 sert à illustrer une structure de circuit de commutation mise en œuvre selon un quatrième mode de réalisation de la présente invention ;
Les figures 12A, 12B sont des vues en coupe partielles d'une portion d'un exemple de circuit intégré de commutation suivant le quatrième mode de réalisation de la présente invention ;
La figure 13 sert à illustrer un convertisseur matriciel AC/AC bidirectionnel en tension et courant dont les cellules élémentaires sont formées chacune d'un circuit de commutation et mis en œuvre suivant la présente invention ;
La figure 14 sert à illustrer un convertisseur matriciel AC/DC dont les cellules élémentaires sont formées chacune d'un circuit de commutation mis en œuvre suivant la présente invention ;
La figure 15 sert à illustrer un convertisseur matriciel DC/AC dont les cellules élémentaires sont formées chacune d'un circuit de commutation bidirectionnel en tension et courant et mis en œuvre suivant la présente invention ;

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

La figure 4 est une illustration schématique d'un circuit de commutation C₁₀ tel que mis en œuvre suivant l'invention et configuré pour fonctionner comme un interrupteur 4-quadrants, bidirectionnel en tension et en courant.

Le circuit de commutation C₁₀ est doté de deux nœuds NA, NB et comporte, entre ces noeuds NA, NB, une première branche 47A dont une extrémité est reliée au premier nœud NA et dont une autre extrémité est reliée au deuxième nœud NB. Une deuxième branche 47B du circuit mise en parallèle avec la première branche est également pourvue d'une extrémité reliée au premier nœud NA et d'une autre extrémité reliée au deuxième nœud NB.

Le circuit C₁₀ comprend un premier transistor T₁ et un deuxième transistor T₂, chacun de type à hétérojonction à effet de champ, en particulier à haute mobilité, avantageusement à haute mobilité d'électrons (HEMT), ainsi qu'une première diode 41, et une deuxième diode 42, en particulier des diodes de type Schottky dotées chacune d'une électrode métallique en contact avec une bande d'hétéro-jonction (non-représentée sur la figure 4). La bande d'hétérojonction est typiquement dotée de deux couches semi-conductrices accolées en particulier empilées et à base de matériaux de gap différents. L'hétérojonction peut être réalisée par exemple par le biais d'un empilement AIGaN/GaN. Plus précisément, la première branche 47A inclut la première diode 41 en série avec le premier transistor T₁, tandis que la deuxième branche 47B, parallèle à la première branche 47A, inclut le deuxième transistor T₂ en série avec la deuxième diode 42. Les diodes 41, 42 sont connectées en anti-série l'une par rapport à l'autre. Ainsi, lorsque la première diode 41 est passante, un courant provenant du premier nœud NA est susceptible de traverser la première diode 41, tandis que lorsque la deuxième diode 42 est passante, un courant en provenance du deuxième nœud NB est susceptible de traverser la deuxième diode 42.

Le premier nœud NA est connecté à une première électrode de conduction, ici de source S2 du deuxième transistor T₂ et à une anode 43, de la première diode Schottky 41, tandis que le deuxième nœud NB est connecté à une première électrode de conduction, ici de source S1 du premier transistor T₁ et à une anode 45, de la deuxième diode Schottky 42. Le premier transistor T₁ et le deuxième transistor T₂ peuvent être dotés chacun d'une deuxième électrode de conduction D1, D2, ici de drain, les deuxièmes électrodes de conduction D1 et D2 étant connectées à une autre électrode, ici la cathode, respectivement de la première diode 41 et de la deuxième diode 42.

Le premier transistor T₁ et le deuxième transistor T₂ sont également pourvus chacun d'une grille de commande G₁, G₂ pour permettre de contrôler l'état de conduction des transistors T₁ et T₂. Les potentiels de commande appliqués respectivement aux transistors déterminent s'ils sont dans un état passant ou bloqué et l'établissement sélectif d'un courant entre les électrodes de conduction. Les grilles peuvent être commandées indépendamment l'une de l'autre par le biais d'un circuit de commande (non illustré) relié à ces grilles de commandes G1, G2. Les tensions de commandes des grilles sont appliquées respectivement par rapport aux électrodes S1 et S2.Lorsque l'on considère que la connexion entre les électrodes de drain D1 et D2 est optionnelle les diodes sont en anti parallèle l'une par rapport à l'autre.

Une configuration alternative sans prévoir de piste conductrice spécifique sur la zone active pour relier entre elles les électrodes de drain est possible. Un tel circuit permet de former un interrupteur de puissance avec un fonctionnement bidirectionnel en courant et/ou en tension avec des pertes de conduction réduites.

L'utilisation de transistors T₁, T₂ à hétérojonction rend le circuit de commutation particulièrement adapté pour des applications de puissance, puisque ces transistors T₁, T₂ présentent une tension de claquage élevée, avec une résistance de conduction réduite et une densité de courant potentiellement élevée.

Le circuit de commutation a ici pour particularité d'avoir le premier transistor T₁, le deuxième transistor T₂, la première diode 41, la deuxième diode 42 qui sont formés à partir d'une même bande d'hétérojonction dans laquelle un gaz d'électrons est susceptible de s'étendre. Ainsi, on prévoit de réaliser les deux branches 47A, 47B du circuit dans une seule et même bande d'hétérojonction formant une seule et même zone active. Cela est possible du fait qu'une portion des diodes est réalisée dans l'empilement de couches semi-conductrices formant l'hétérojonction.

Cela permet un gain en compacité important, ce qui favorise la densité d'intégration. Un gain de surface d'un facteur 2 peut être en particulier obtenu par rapport à une structure telle que présentée précédemment en lien avec la figure 3B, et un facteur 3 peut être obtenu par rapport à un circuit formé de quatre composants discrets. Outre le gain de place, une telle configuration permet de rendre le procédé de fabrication du circuit moins onéreux.

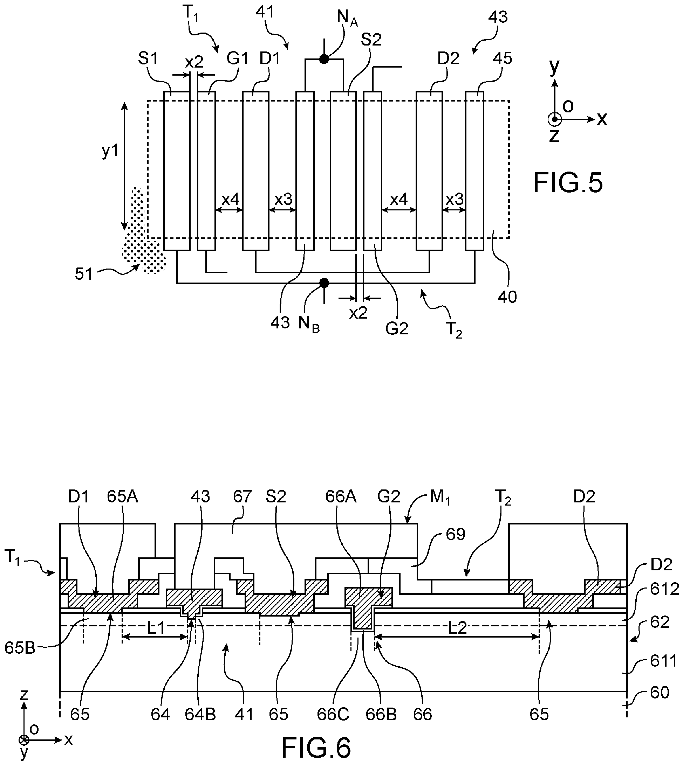

La figure 5 donne une vue de dessus d'un premier exemple de topographie d'un tel circuit de commutation, avec une zone active 40, dans laquelle un gaz d'électrons est susceptible d'être formée, représentée ici de manière schématique par un cadre en trait discontinu.

Le premier transistor T₁ et le deuxième transistor T₂, ainsi que la première diode Schottky et la deuxième diode Schottky sont disposés le long d'une même bande d'hétérojonction, qui peut avoir une forme allongée, et destinée à former la zone active 40. La bande d'hétérojonction est réalisée sur un substrat qui n'est pas représenté sur cette figure mais dont un plan principal s'étend parallèlement au plan [O ; x ; y] du repère orthogonal [O ; x; y; z] donné sur la figure 5.

Dans l'exemple de réalisation particulier illustré, la zone active 40 a une forme rectangulaire ou sensiblement rectangulaire avec une première dimension (non référencée) en particulier sa longueur mesurée parallèlement à une première direction suivant l'axe x du repère orthogonal [O; x; y; z], et une deuxième dimension y1, en particulier sa largeur, mesurée parallèlement à une deuxième direction suivant l'axe y du repère orthogonal [O ; x ; y ; z].

L'agencement est ici prévu de sorte que le circuit comporte dans la première direction : une première électrode de conduction du premier transistor T₁, ici sa source S1, la grille de commande G1 du premier transistor T₁, une deuxième électrode de conduction du premier transistor T₁, ici son drain D1, une électrode métallique 43 de la première diode 41, une première électrode de conduction du deuxième transistor T₂, ici sa source S2, la grille de commande G2 du deuxième transistor T₂, une deuxième électrode de conduction du deuxième transistor T₂, ici son drain D2, une électrode métallique 45 de la première diode 41.

Avantageusement, les électrodes S1, G1, D1, 43, S2, G2, D2, 45 sont disposées parallèlement les unes aux autres et s'étendent orthogonalement à la première direction, autrement dit sont dirigées dans le sens de la largeur de la bande d'hétérojonction.

Dans cet exemple de réalisation, l'agencement des électrodes S1, G1, D1, 43, S2, G2, D2, 45 est tel qu'elles recouvrent la zone active 40 sur toute sa largeur y1. Ainsi, la première électrode métallique 43 et la deuxième électrode métallique 45 forment des bandes métalliques qui s'étendent parallèlement à la deuxième direction y et ont des longueurs respectives qui peuvent être supérieures ou égales à la largeur y1 de la zone active 40. Pour délimiter la zone active 40, la bande d'hétérojonction peut être entourée d'une structure 51 configurée pour empêcher la présence du gaz 2D autour de ladite bande d'hétérojonction par exemple une zone isolante ou bien une zone dopée, par exemple une zone dopée à l'Argon et formée dans l'empilement de matériaux de différents Gap dans lequel la bande d'hétérojonction est réalisée.

On prévoit ici avantageusement pour chaque transistor T₁, T₂ une distance x2, x'2 (dimensions mesurées parallèlement à la première direction x) entre sa grille G1, G2 et sa source S1, S2 suffisante pour supporter la tension de polarisation de grille entre la grille et la source. Une distance x4 (dimension mesurée parallèlement à la première direction x) entre sa grille G1, G2 et son drain D1, D2 est quant à elle prévue de préférence suffisante pour supporter la tension de polarisation entre drain et grille. Dans l'exemple de réalisation particulier illustré, x2 est inférieure à x4.

On prévoit également de préférence une distance x3, (dimension mesurée parallèlement à la première direction x) entre l'électrode métallique 43, 45 de chacune des diodes Schottky 41, 42 et le drain D1, D2 du transistor donné avec lequel cette diode est mise en série égale à la distance x4 suffisante pour supporter la tension entre contact Schottky et drain. Dans l'exemple de réalisation particulier illustré, x3 est égale à x4.

Le tableau ci-dessous donne des exemples de valeurs de ces dimensions x2, x3, x4, et de celle des électrodes et de la zone active pour l'agencement de la figure 5, Xschot, XD1, XG1, XS1, XD2, XG2, XS2 correspondant aux largeurs (dimensions mesurées parallèlement à la première direction x) respectives des électrodes 41 et 45, D1, G1, S1, D2, G2, S2, et ce pour supporter une tension de l'ordre de 650 V et un courant de l'ordre de 50 mA.

**Tableau 1**

| Exemple de dimensions pour l'agencement de la figure 5 | Unité : µm |
|---|---|
| X2 | 0.5 |
| x3 | 10 |
| x4 | 10 |
| Xschott | 1 |
| XD1 | 1 |
| XG1 | 0.5 |
| XS1 | 1 |
| XD2 | 1 |
| XG2 | 0.5 |
| XS2 | 1 |
| Total x | 48 |
| | |
| y1 | 500 |
| Total y | 500 |

Sur la figure 6, une vue en coupe d'une partie du circuit de commutation est donnée. Le deuxième transistor T₂ pourvu de ses électrodes D2, G2, S2, la première diode 41 dont l'électrode métallique 43 est située entre le premier transistor T₁, en particulier son drain D1 et le deuxième transistor T₂, en particulier sa source S2 sont représentés. La source, la grille du premier transistor T₁ ainsi que l'électrode métallique de la deuxième diode ne sont ici en revanche pas montrées. Les deux branches de circuit sont donc réalisées à partir d'une même bande d'hétérojonction 62 dans laquelle une couche de gaz d'électrons 2Deg est matérialisée de manière schématique par un trait pointillé. La bande d'hétérojonction 62 repose sur un substrat 60 qui peut être semi-conducteur, par exemple en silicium ou en GaN ou en un autre type de matériau. Un substrat saphir (Al₂O₃) peut être en particulier utilisé.

Les électrodes de source et de drain des transistors T₁, T₂ sont typiquement sous forme de contacts ohmiques 65 formés d'une zone 65A de métal en contact avec une région semi-conductrice 65B de la bande d'hétérojonction 62 dans laquelle du métal a diffusé. En variante d'une diffusion métallique, la région semi-conductrice 65B des électrodes de source ou de drain peut être une zone dopée réalisée par implantation ionique. L'électrode métallique 43 de chaque diode 41 forme un contact Schottky 64 avec une région semi-conductrice 64B de la bande d'hétérojonction 62. Les régions semi-conductrices 64B, 65B sont en particulier des zones d'une couche semi-conductrice supérieure 612 d'un empilement formant l'hétérojonction. Cette couche semi-conductrice supérieure 612 est typiquement une couche dite barrière, formée d'alliage ternaire d'un nitrure d'un élément de type III tel que par exemple de l'AIGaN.

Dans l'exemple de réalisation particulier illustré sur la figure 6, l'électrode métallique 43 (resp. 45) de chaque diode Schottky 41 (resp. 42) est connectée à une électrode de conduction, en particulier la source S2 du transistor T₂ de l'autre branche par le biais d'une zone de connexion 67 métallique formée dans un premier niveau métallique M₁ de connexions. Cette zone de connexion métallique 67 est ici plus précisément en contact avec la zone de métal de l'électrode de source et peut être également reliée à une électrode 69 de plaque de champ (« field plate » selon la terminologie anglo-saxonne) placée en regard d'une portion de la grille du transistor T₂ (resp. T₁). Une telle plaque de champ peut permettre d'éviter un pic de champ électrique au pied d'une zone isolante 66B servant de diélectrique de grille.

Dans cet exemple de réalisation particulier, les grilles de commande G1, G2 forment un contact 66 de grille sous forme d'une structure de type MIS (Pour « Métal Isolant Semi-conducteur ») comportant une zone métallique 66A reposant sur une zone isolante 66B en contact avec une zone semi-conductrice 66C de la bande d'hétérojonction. L'empilement de la zone métallique 66A et de la zone isolante 66B est ici agencé dans une tranchée dont le fond est situé dans la bande d'hétérojonction, en particulier dans une couche semi-conductrice inférieure 611 formant avec ladite couche semi-conductrice supérieure 612 l'hétérojonction.

La couche semi-conductrice inférieure 612 peut être prévue en alliage binaire d'un nitrure d'un élément de type III, par exemple du GaN. Ainsi, la grille G1, G2 s'étend dans cet exemple sous le niveau dans lequel la couche de gaz d'électrons 2Deg, cette dernière étant typiquement située à l'interface entre la couche semi-conductrice inférieure 611 et la couche semi-conductrice supérieure 612.

En variante, d'autres configurations de grille avec ou sans tranchée peuvent être prévues. Entre autres agencements, une grille disposée directement sur la couche barrière, une grille disposée sur une couche dopée reposant la couche barrière, une grille agencée sur une zone implantée de la couche barrière peuvent être également prévues.

On prévoit de préférence le dimensionnement de chaque portion de diode Schottky 41 (resp. 42) dans la bande d'hétérojonction 62 avec une première distance minimale L₁ supérieure à un seuil donné entre une zone de l'électrode métallique 43 (resp. 45) en contact avec la bande d'hétérojonction et une zone de drain D1 (resp. D2) du transistor T₁ (resp. T₂) avec lequel cette diode 41 est disposée en série. Une telle distance est dépendante et en particulier proportionnelle à une tenue en tension recherchée pour la structure.

De même, on choisit de préférence le dimensionnement de chaque transistor T₂ (resp. T₁) avec une deuxième distance L₂ minimale supérieure à un seuil donné entre une région de la bande d'hétérojonction contre laquelle sa grille G2 (resp. G1) est formée et son drain D2 (resp. D1). Une telle distance est également dépendante et en particulier proportionnelle à une tenue en tension recherchée pour la structure.

Par exemple, dans un cas où l'on souhaite obtenir une tenue bidirectionnelle en tension de l'ordre de 650V on peut prévoir la première distance L₁ par exemple d'au moins 10 µm. La deuxième distance L₂ peut, quant à elle, être prévue par exemple d'au moins 10 µm. Ces distances L₁, L₂ dépendent de la constitution de la bande d'hétérojonction et en particulier du matériau de grand gap formant cette hétérojonction. Dans le cas, par exemple, où ce matériau à grand gap est du GaN, on peut déterminer ces valeurs en considérant une tenue avant claquage de l'ordre de 3MV/cm et typiquement en prévoyant une marge afin d'éviter un champ électrique supérieur à 0.3 MV/cm.

Bien que l'on ait évoqué précédemment un cas particulier de transistor à hétérojonction de type AlGaN/GaN, d'autres structures avec des hétérojonctions différentes par exemple telle que GaAlAs/GaAs, ou GaAlAs(N+)/InGaAs(n.d)/GaAs peuvent également être envisagées.

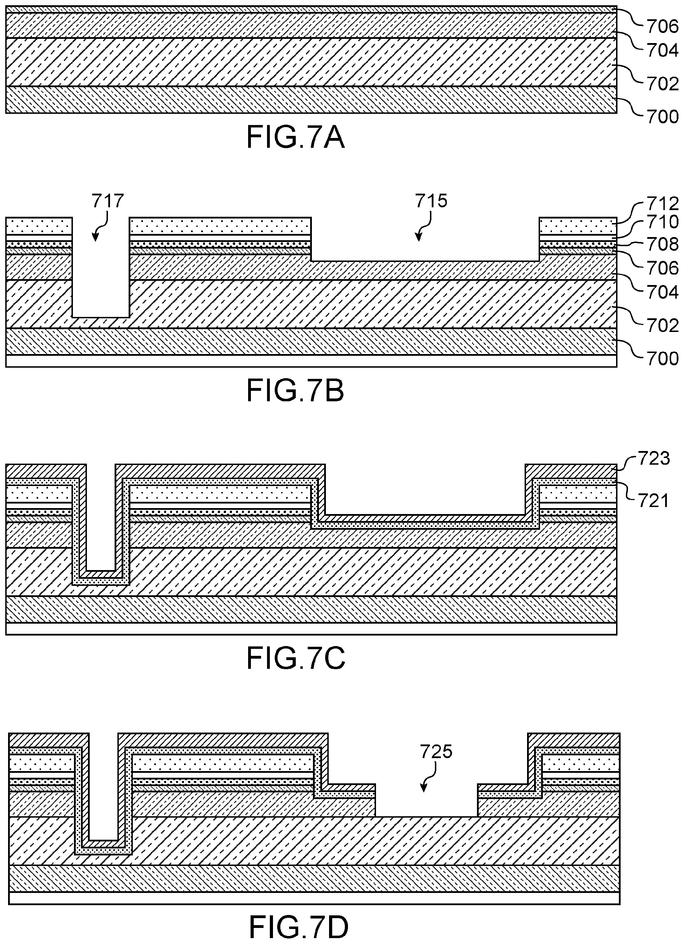

Un exemple d'enchainement d'étapes d'un procédé de fabrication d'un circuit de commutation du type de celui décrit précédemment va à présent être illustré en lien avec les figures 7A à 7I.

Un matériau de départ possible du procédé est un substrat 700, qui peut être semi-conducteur, par exemple en silicium d'épaisseur par exemple de l'ordre de 1 mm. Le substrat 700 est revêtu d'une première couche semi-conductrice 702, en particulier à base d'un semi-conducteur à large bande interdite et de type III/V par exemple comme le GaN. La première couche semi-conductrice 702 est elle-même revêtue d'une deuxième couche semi-conductrice 704 qui peut être formée par épitaxie et en particulier à base d'un matériau à gap direct tel que par exemple du nitrure d'aluminium-gallium (AlₓGa₁₋ₓN). Cette couche 704 forme avec la première couche semi-conductrice 702 une hétéro-jonction et une couche de gaz d'électrons est intrinsèquement formée à l'interface entre ces deux couches 702, 704.

Comme illustré sur la figure 7A, une première couche de passivation 706 peut alors être déposée sur la deuxième couche semi-conductrice 704. Cette première couche de passivation 706 est en un matériau isolant tel que par exemple du nitrure de silicium.

Dans l'exemple de réalisation illustré sur la figure 7B, la première couche diélectrique de passivation 706 est ensuite revêtue d'autres couches de passivation de sorte à former une alternance de couches 706, 710 en un matériau isolant par exemple du nitrure de silicium et de couches 708, 712 en un autre matériau isolant tel que par exemple de l'oxyde de silicium.

Une ou plusieurs étapes de gravure des couches de passivation 706, 708, 710, 712 peuvent alors être mises en œuvre pour former des ouvertures dont une première ouverture 715 donnant accès à la seconde couche semi-conductrice 704 et une deuxième ouverture 717 réalisée à travers la seconde couche semi-conductrice 704 et dévoilant la première couche semi-conductrice 702. Dans l'exemple de réalisation particulier illustré sur la figure 7B, la réalisation de la première ouverture 715 comprend le retrait d'une portion supérieure de la deuxième couche semi-conductrice 704.

Selon un exemple de réalisation particulier, pour réaliser la première ouverture 715, une épaisseur de l'ordre de 10 nm peut être retirée d'une couche semi-conductrice 706 d'AIGaN d'épaisseur de l'ordre de 25 nm. Selon ce même exemple, pour réaliser la deuxième ouverture 717, une épaisseur de l'ordre de 80 nm peut être retirée d'une couche semi-conductrice 702 de GaN d'épaisseur de l'ordre de 4 µm.

Ensuite, on forme dans les ouvertures et notamment dans la première ouverture 715 et la deuxième ouverture 717 une couche diélectrique 721. Cette couche diélectrique 721 est par exemple à base d'Al₂O₃ et d'épaisseur de l'ordre de 30 nm et peut être formée par technique ALD (pour « Atomic Layer Déposition » ou dépôt de couche atomique).

Puis (figure 7C), une couche métallique 723 est déposée. Cette couche métallique 723 est par exemple à base de TiN et d'épaisseur de l'ordre de 60 nm et peut être formée par technique PVD (pour « Physical Vapor Déposition » soit « dépôt physique en phase vapeur »).

On réalise ensuite (figure 7D) au moins un orifice 725 au niveau de l'empilement situé dans la première ouverture 715 afin de dévoiler la première couche semi-conductrice 704. Un tel orifice 725 est typiquement réalisé par photolithographie et gravure, par exemple à l'aide de plasma (gravure sèche).

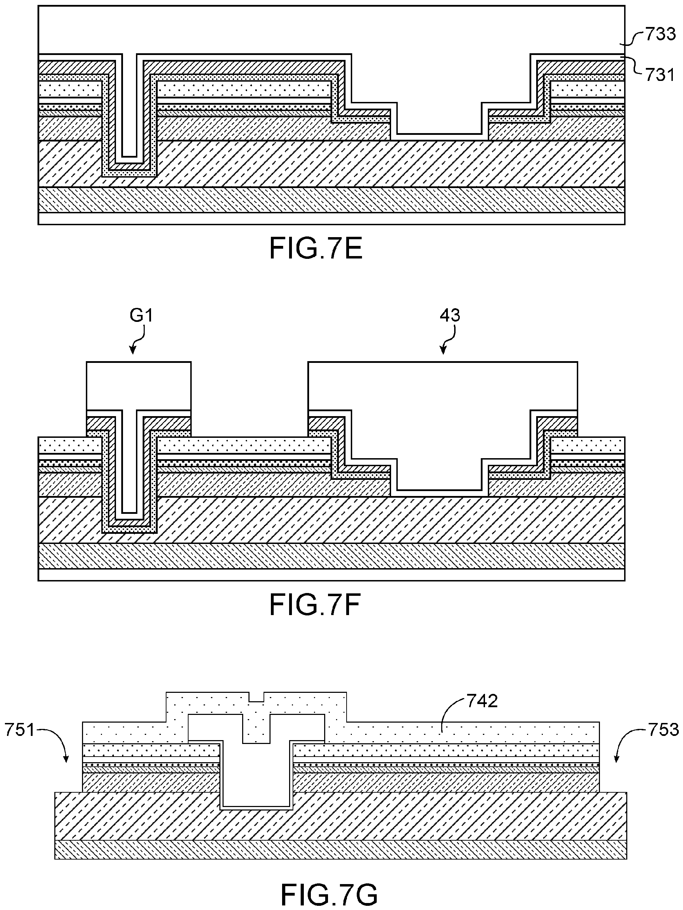

Puis (figure 7E), on dépose une ou plusieurs couches métalliques. Typiquement on réalise un empilement d'une fine couche métallique 731, par exemple à base de TiN de 60 nm et d'au moins une autre couche de métal 733, par exemple du tungstène d'épaisseur de l'ordre de 300 nm, afin de réaliser dans l'orifice 725, un contact de type Schottky. Ces couches métalliques 731, 733 peuvent servir également à combler la deuxième ouverture 725.

On forme ensuite un ou plusieurs motifs par gravure de l'empilement de couches 721, 723, 731, 733 de manière à définir des électrodes. Sur la figure 7F, une électrode de grille G1 du premier transistor T₁ et une électrode métallique 43 de la première diode 41 sont représentées.

Les électrodes peuvent ensuite être recouvertes d'une couche isolante 742 (figure 7G). La couche isolante 742 est réalisée par exemple en SiO₂. Une technique de PECVD pour (« Plasma-Enhanced Chemical Vapor Déposition » ou dépôt chimique en phase vapeur assisté par plasma) peut être employée pour réaliser une épaisseur par exemple de l'ordre de 150 nm.

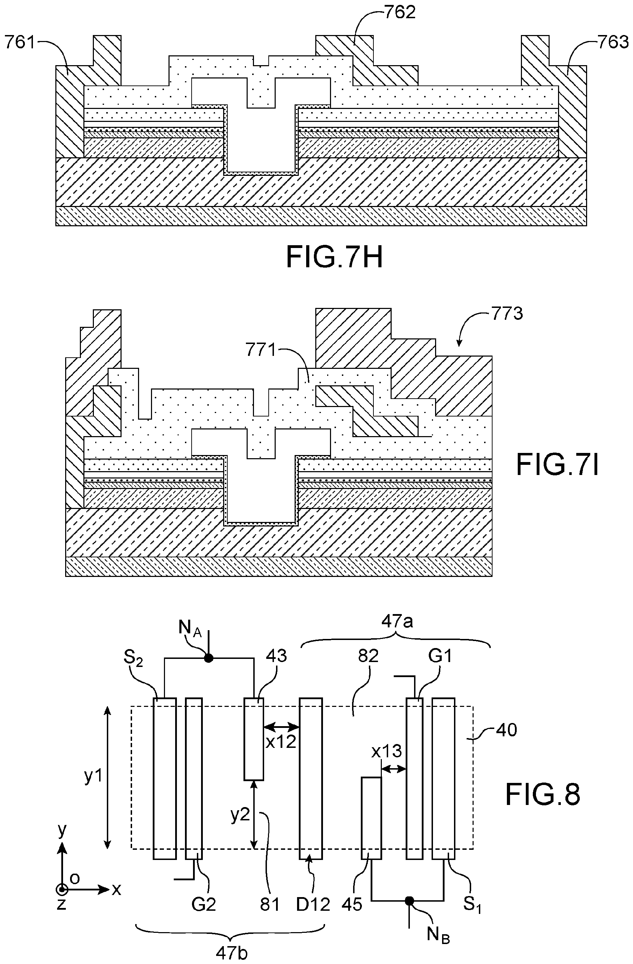

On peut ensuite définir un ou plusieurs éléments de connexion 761, 762, 763 dont certains 761, 763 sont en contact avec la première couche semi-conductrice 702 (figure 7H). On réalise pour cela tout d'abord des trous 751, 753 dévoilant la première couche semi-conductrice 702. La réalisation de tels trous 751, 753 peut comprendre une ou plusieurs étapes de gravure sèche. Puis, on dépose un ou plusieurs matériaux métalliques. Par exemple, on forme tout d'abord une couche puis une couche barrière telle qu'une couche de TiN de 60nm selon un procédé de dépôt qui peut être de type PVD (pour « Physical Vapor Deposition »), puis une couche d'alliage d'aluminium et de cuivre AI:Cu de l'ordre de 200 nm.

On forme ensuite une autre couche isolante 771 puis un premier niveau 773 métallique d'interconnexion (figure 7I). On dépose pour cela un ou plusieurs matériaux métalliques. Par exemple, on forme tout d'abord une couche de Ti de l'ordre de 20 nm, puis une couche de TiN de l'ordre de 20 nm et d'aluminium. On peut compléter le dépôt par exemple par une couche de cuivre de l'ordre de 1.4 µm, de Ti de l'ordre de 20 nm, et de TiN de l'ordre de 40 nm. De telles couches métalliques peuvent être formées par exemple par PVD.

Selon une variante de réalisation de la structure décrite précédemment, afin de limiter encore davantage l'encombrement des transistors T₁, T₂, on peut prévoir comme dans l'exemple de réalisation illustré sur la figure 8, un agencement avec une électrode de drain D₁₂ commune au premier transistor T₁ et au deuxième transistor T₂. On peut réunir ainsi les électrodes de drain en un seul contact ohmique et éviter d'utiliser une connexion métallique supplémentaire au-dessus.

Dans l'exemple de réalisation illustré, les électrodes métalliques 43, 45 des diodes 41, 42 ont également, de manière avantageuse, une longueur rétrécie par rapport aux autres électrodes et en particulier par rapport à l'électrode de drain D₁₂ commune. Les électrodes métalliques 43, 45 ne s'étendent ainsi en regard que d'une partie seulement de la largeur y1 de la zone active 40. Une portion 81 de la zone active 40 située dans le prolongement de la première électrode métallique 43 et qui s'étend dans la deuxième direction y, n'est pas recouverte par la première électrode métallique 43. De même, une autre portion 82 de la zone active 40 située dans le prolongement de la deuxième électrode métallique 45 et qui s'étend dans la deuxième direction y n'est pas recouverte par la deuxième électrode métallique 45. Un tel agencement permet une meilleure compacité, les portions 81, 82 de la zone active servant dans ce cas de région de canal respectivement du deuxième transistor T2 et du premier transistor T1. Les deux régions de canal sont ici décalées l'une par rapport à l'autre.

Le tableau ci-dessous donne des exemples de valeurs de certaines dimensions de cet agencement, avec notamment x₁₂ : une distance mesurée parallèlement à la première direction x entre l'électrode de drain D₁₂ commun et la première et/ou la deuxième électrode métallique 43, 45, x₁₃ : une distance mesurée parallèlement à la première direction x entre la grille de commande G1 (resp. G2) et l'électrode métallique de la diode D2 appartenant à la branche opposée, y2 la longueur des portions 81, 82 situées dans le prolongement respectif des électrodes métalliques et mesurée parallèlement à la deuxième direction y, Xschot, XD1, XG1, XS1, XD2, XG2, XS2 correspondant dans le cas de figure d'un circuit supportant une tension de l'ordre de 650 V et un courant de l'ordre de 50 mA.

**Tableau 2**

| Agencement de la Figure 8 | Unité : µm |
|---|---|
| X12 | 10 |
| X₁₃ | 10 |
| Xschott | 1 |
| XD1 | 0 |
| XG1 | 0.5 |
| XS1 | 1 |
| XD2 | 0 |
| XG2 | 0.5 |
| XS2 | 1 |
| Total x | 46 |
| | |
| y1 | 500 |
| y2 | ≤ 250 |
| Total y | 500 |

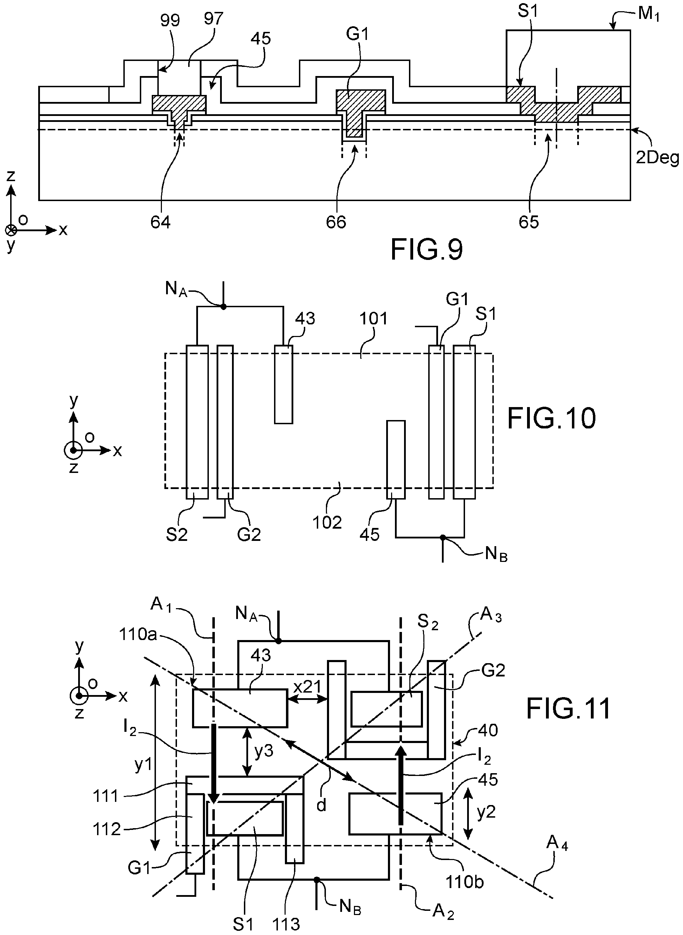

Sur la figure 9, une vue en coupe partielle (selon un plan de coupe parallèle au plan [O ; x; z]) de ce même circuit de commutation est donnée. Seule une partie du premier transistor et de la deuxième diode 43 sont représentées, mais les deux branches ont des structures semblables. L'électrode de source S1 du premier transistor T₁, est sous forme de contact ohmique 65, la grille G1 formant une structure 66 MIS et l'électrode métallique de la deuxième diode métallique 45 formant un contact Schottky 64. L'électrode métallique 45 la deuxième diode Schottky 42 est connectée ici à une électrode 99 de plaque de champ (« field plate » selon la terminologie anglo-saxonne) par l'intermédiaire d'une zone de connexion 97 métallique formée dans un premier niveau métallique M₁ de connexions.

Une variante de l'exemple de réalisation décrit précédemment en liaison avec la figure 10, prévoit un agencement sans électrode de drain métallique ou sans zone métallique pour former l'électrode de drain des transistors T₁, T₂. Les drains des transistors T₁, T₂ des transistors sont alors constitués respectivement dans des zones 101, 102 de la bande d'hétérojonction ce qui permet de gagner à nouveau en compacité du circuit.

Un autre exemple d'agencement du circuit de commutation est donné sur la figure 11. Le circuit comporte cette fois en regard de la zone active 40 dans une première direction parallèle à l'axe x du repère [O ; x ; y; z] et au plan principal du substrat, l'ensemble des éléments formant la première branche située dans une première région 110a de la zone active 40, et l'ensemble des éléments formant la deuxième branche située dans une deuxième région 110b de ladite zone active 40 juxtaposée à la première région 110.

La première branche comporte, sur un axe donné A1 suivant une deuxième direction réalisant un angle non-nul avec la première direction et en particulier orthogonal à la première direction: la première électrode métallique 43, la grille G1 de commande du premier transistor T₁, l'électrode de source S1 du premier transistor T₁.

La deuxième branche comporte, sur un axe A2 qui peut être parallèle au premier axe A1 et à la deuxième direction réalisant un angle non-nul avec la première direction et en particulier orthogonal à la première direction: l'électrode de source S2 du deuxième transistor T₂, la grille G2 de commande du deuxième transistor T₂, la deuxième électrode métallique 45. Dans cette configuration les contacts de drain sont supprimés. Ainsi, il n'est ici pas nécessaire de prévoir de piste supplémentaire spécifique ou de contact ohmique pour réaliser les électrodes de drain. L'électrode de drain est alors uniquement constituée d'une portion de l'empilement semi-conducteur formant la bande d'hétérojonction.

L'électrode métallique 43 de la première diode et l'électrode métallique 45 de la deuxième diode sont réparties sur un axe A4 réalisant un angle non-nul avec les axes A1 et A2, tandis que la grille G1 de commande du premier transistor T₁ et la grille G2 de commande du deuxième transistor T2 sont réparties sur un axe A3 réalisant un angle non-nul avec les axes A1, A2, A3.

Lorsque la première branche 47a est passante (i.e. lorsque la première diode 41 et le premier transistor T₁ sont passants) un courant I₁ orienté suivant l'axe A1 est susceptible de circuler entre une partie de la bande d'hétérojonction située en regard de la première électrode métallique 43 et une partie de la bande d'hétérojonction située en regard de l'électrode de source S1 du premier transistor T1.

Lorsque la deuxième branche 47b est passante (i.e. lorsque la deuxième diode 42 et le premier transistor T₂ sont passants) un courant I₂ orienté suivant l'axe A2 est susceptible de circuler entre une partie de la bande d'hétérojonction située en regard de la deuxième électrode métallique 45 et une partie de la bande d'hétérojonction située en regard de l'électrode de source S2 du deuxième transistor T2. Les courants I₁ et I₂ circulent ainsi dans la bande d'hétérojonction dans une même direction mais des sens opposés l'un de l'autre.

De manière avantageuse, les grilles de commande G1 et G2 entourent partiellement respectivement l'électrode de source S1 du premier transistor T₁ et l'électrode de source S2 du deuxième transistor T₂. Les grilles G1, G2 ne sont donc ici pas formées d'une zone rectiligne mais de portions qui s'étendent dans des directions différentes l'une de l'autre. Dans l'exemple de réalisation illustré sur la figure 11, les grilles G1, G2 ont une forme de 'U' autour des électrodes de source S1, S2. En particulier, les grilles G1, G2 ont une portion 111 qui s'étend dans une première direction, ici parallèle à celle correspondant à la longueur de la zone active et des portions 112, 113 qui s'étendent dans une première direction, ici parallèle à celle x dans laquelle la longueur de la zone active est mesurée. La configuration des grilles G1, G2 permet de réaliser une isolation réglable entre les différents composants formant les deux branches du circuit. Un tel mode de réalisation est adapté en particulier à des applications fonctionnant dans des gammes de courant plus faibles que celles des modes de réalisation décris précédemment. Dans l'exemple de réalisation particulier représenté, les grilles G1, G2 en forme de 'U' sont disposées tête bêche l'une par rapport à l'autre.

On prévoit une distance x₂₁ donnée (dimension mesurée parallèlement à la direction x) entre chaque grille G1, G2 de transistor T₁, T₂ et l'électrode métallique 45, 43 de l'autre branche. On peut également prévoir une distance y3 (dimension mesurée parallèlement à la direction y) entre l'électrode métallique 43, 45 de chacune des diodes Schottky 41, 42 et la grille du transistor T₁, T₂ de la branche dans laquelle cette diode est agencée. On peut également prévoir une distance d > y3 entre les deux électrodes métalliques 43, 45 des diodes Schottky 41, 42.

Le tableau ci-dessous donne des exemples de valeurs de ces dimensions et de celle des électrodes et de la zone active pour l'agencement de la figure 11 pour supporter une tension de l'ordre de 650 V et un courant de l'ordre de 50 mA.

**Tableau 3**

| Dimensions de l'exemple de réalisation de la figure 11 | Unité: µm |
|---|---|
| x1 | 0.5 |
| x21=x2 | 0.5 |
| Xschott | 500 |
| XG1 | 0.5 |
| XS1 | 500 |
| Total x | 1002.5 |
| | |
| y1 | 1+0-5+05+10+1 |
| y20=y2 | 1 |
| y3 | 10 |
| Total y | 24 |
| | |
| Surface Totale | 24060 |

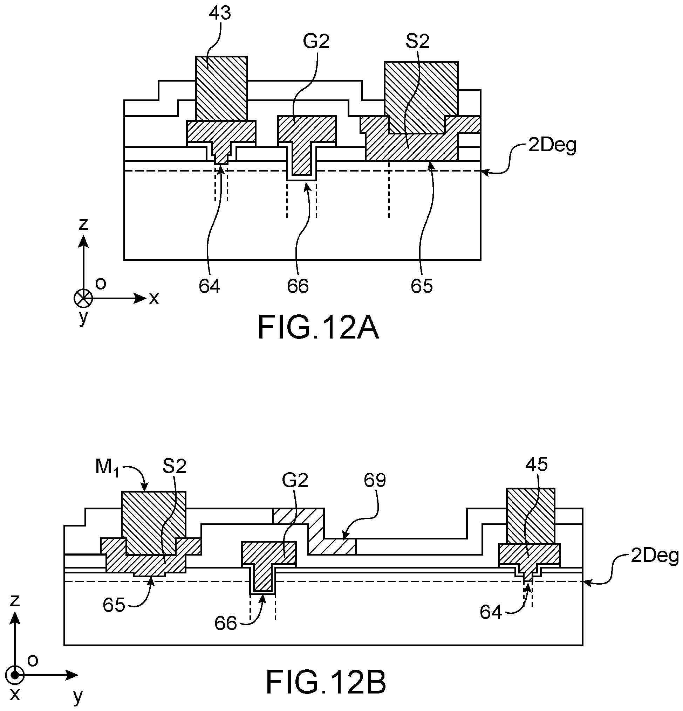

Les figures 12A-12B donnent des vues en coupe, respectivement suivant un plan de coupe parallèle au plan [O ; x ; y] du repère orthogonal [O ; x ; y ; z] et un plan de coupe parallèle au plan [O ; y ; z] de l'exemple de configuration précédemment donné.

Les électrodes métallique 43, 45 respectivement de la première diode, de la deuxième diode forment là encore des contacts 64 Schottky, tandis que les grilles G1, G2 forment une structure 66 de type MIS. La première électrode de conduction, ici la source S1, S2 des transistors T1, T2 est là encore sous forme d'un contact ohmique 65.

Les électrodes métallique 43, 45 et électrodes de sources sont ici revêtues de plots de connexion formés dans un premier niveau de métallique M₁.

L'une ou l'autre des structures décrites précédemment en lien avec les figures 5, 8, 10, 11 peut être répétée plusieurs fois sur une même bande d'hétérojonction pour former un circuit de commutation.

Bien que les exemples de réalisation du circuit de commutation aient été décrits avec des transistors T₁, T₂ à effet de champ à hétérojonction à haute mobilité d'électrons, on peut en variante de l'un ou l'autre des modes de réalisation présentés précédemment prévoir d'y intégrer des transistors à effet de champ à hétérojonction à haute mobilité de trous. Un circuit de commutation à fonctionnement bidirectionnel peut par ailleurs être utilisé comme interrupteur de puissance dans un dispositif électronique de puissance et en particulier dans un convertisseur matriciel.

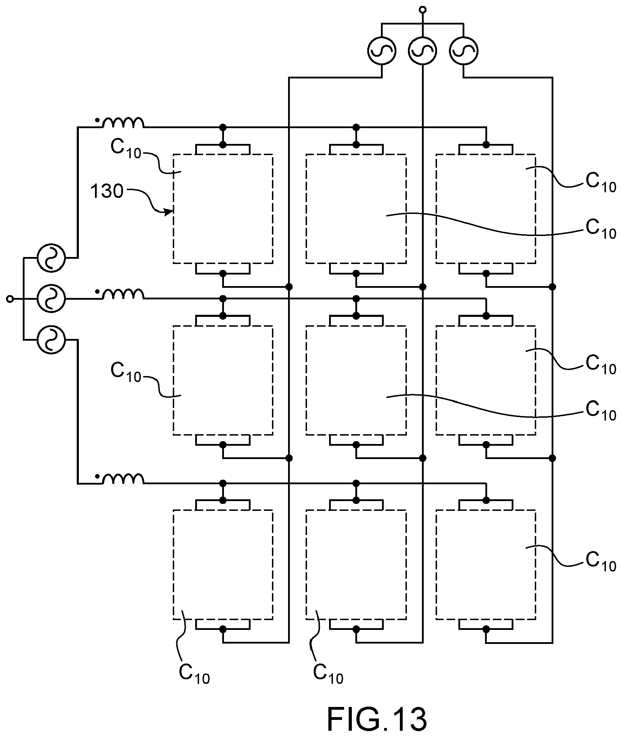

Par exemple, comme cela est illustré sur la figure 13, un convertisseur matriciel AC/AC est formé d'une matrice de cellules 130, dans cet exemple une matrice 3^{∗}3 chacune pourvue d'au moins un circuit de commutation C₁₀ dont le schéma de principe a été présenté sur la figure 4 et mis en œuvre suivant l'un ou l'autre des exemples de réalisation décrits précédemment.

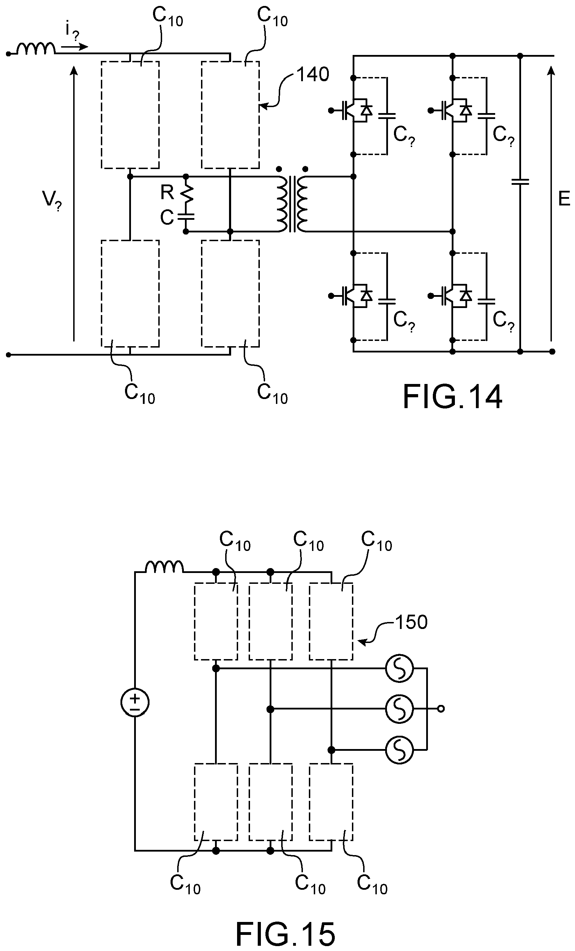

Selon un autre exemple d'application donné sur la figure 14, un convertisseur matriciel AC/AC comporte une pluralité de cellules 140, chacune formée d'au moins un circuit de commutation C₁₀.

Un troisième exemple d'application concerne cette fois un convertisseur de type DC/AC et dont les cellules 150 intègrent chacune au moins un circuit de commutation C₁₀ décrit plus haut.

## Revendications

1. Circuit de commutation (C₁₀) formant interrupteur bidirectionnel entre un premier nœud (NA) et un deuxième nœud (NB) et reposant sur un substrat (60), le substrat étant recouvert d'une bande d'hétérojonction (62) formant une zone active (40) dans laquelle un gaz d'électrons est apte à être formé, ledit circuit étant doté :
- d'une première branche (47A) formée, entre une extrémité reliée au premier nœud (NA) et une autre extrémité reliée au deuxième nœud (NB) : d'une première diode (41) en série avec un premier transistor (T₁) à hétérojonction à effet de champ,
- d'une deuxième branche (47B) formée, entre une extrémité reliée au premier nœud (NA) et une autre extrémité reliée au deuxième nœud (NB) : d'un deuxième transistor à hétérojonction à effet de champ (T₂) en série avec une deuxième diode (42), la première branche (47A) et la deuxième branche (47B) étant montées en parallèle l'une de l'autre et de sorte que la première diode (41) et la deuxième diode (42) sont agencées en en anti-série ou en antiparallèle l'une par rapport à l'autre,
le premier transistor (T₁), le deuxième transistor (T₂) étant pourvus chacun d'une grille de commande (G1, G2) en regard de ladite bande d'hétérojonction (62), la première diode (41) étant une diode Schottky pourvue d'une électrode métallique appelée première électrode métallique (43) en contact avec ladite bande d'hétérojonction (62), la deuxième diode (42) étant une diode Schottky pourvue d'une électrode métallique appelée deuxième électrode métallique (45) en contact avec ladite bande d'hétérojonction (62), la première diode (41), le premier transistor (T₁), la deuxième diode (42), le deuxième transistor (T₂) partageant ladite même zone active (40),
dans lequel, ledit circuit comporte, en regard de la zone active (40) dans une première direction (x) parallèle à un plan principal du substrat : une première électrode de conduction (S2) du deuxième transistor (T₂), la grille de commande (G2) du deuxième transistor (T₂), la première électrode métallique (43), la deuxième électrode métallique (45), la grille de commande (G1) du premier transistor (T₁), une première électrode de conduction (S1) du premier transistor (T₁), la première électrode métallique (43) et la deuxième électrode métallique (45) étant agencées entre la grille de commande (G2) du deuxième transistor et la grille de commande (G1) du premier transistor,
dans lequel la première électrode métallique (43) et la deuxième électrode métallique (45) s'étendent parallèlement à une deuxième direction, orthogonale à la première direction, et ont des longueurs respectives mesurées parallèlement à la deuxième direction inférieures à une largeur (y1) de la zone active (40) mesurée dans la deuxième direction, de sorte que dans la deuxième direction une portion (81) de la zone active (40) située dans le prolongement de la première électrode métallique (43') n'est pas recouverte par la première électrode métallique et de sorte que dans la deuxième direction une autre portion (82) de la zone active située dans le prolongement de la deuxième électrode métallique n'est pas recouverte par la deuxième électrode métallique, lesdites portions (81, 82) non recouvertes par les électrodes métalliques (43, 45) formant respectivement une région de canal pour le premier transistor et le deuxième transistor.

2. Circuit de commutation selon la revendication 1, dans lequel ledit circuit (C₁₀) comporte, en regard de la zone active (40) dans cet ordre, et dans une première direction (x) parallèle à un plan principal du substrat : une première électrode de conduction (S1) du premier transistor (T₁), la grille de commande (G1) du premier transistor (T₁), une deuxième électrode de conduction (D1) du premier transistor (T₁), la première électrode métallique (43), une première électrode de conduction (S2) du deuxième transistor (T₂), la grille de commande (G2) du deuxième transistor (T2), une deuxième électrode de conduction (D2) du deuxième transistor, la deuxième électrode métallique (45).

3. Circuit de commutation selon la revendication 2, dans lequel la première électrode métallique (43) et la deuxième électrode métallique (45) s'étendent parallèlement à une deuxième direction, orthogonale à la première direction, et ont des longueurs respectives mesurées parallèlement à la deuxième direction supérieures ou égales à une largeur de la zone active (40) mesurée dans la deuxième direction.

4. Circuit de commutation selon la revendication 1, dans lequel le premier transistor (T₁) et le deuxième transistor (T₂) comportent une deuxième électrode de conduction (D₁₂), la deuxième électrode de conduction étant commune au premier transistor (T₁) et au deuxième transistor (T₂), ladite deuxième électrode de conduction commune (D₁₂) étant agencée entre la première électrode métallique (43) et la deuxième électrode métallique (45).

5. Circuit de commutation selon l'une des revendications 1 à 4, le premier transistor (T₁) et/ou le deuxième transistor (T₂) ayant une première électrode de conduction (S1, S2) et une deuxième électrode de conduction (D1, D2) formée d'un contact ohmique.

6. Circuit de commutation selon la revendication 1, dans lequel le premier transistor et le deuxième transistor comportent chacun une première électrode de conduction (S1, S2) comprenant une zone métallique (65A) en contact avec ladite bande d'hétérojonction, et dans lequel le premier transistor et le deuxième transistor comportent une deuxième électrode (D1, D2) de conduction constituée par une zone (101, 102) de ladite bande d'hétérojonction.

7. Circuit de commutation selon l'une des revendications 1 à 6, dans lequel ladite bande d'hétérojonction (60) est entourée d'une structure (61) configurée pour empêcher la diffusion du gaz 2D autour de ladite bande d'hétérojonction telle qu'une zone isolante ou une zone dopée, en particulier dopée à l'Argon.

8. Circuit de commutation selon l'une des revendications 1 à 7, dans lequel, lesdits premier et deuxième transistors (T1, T2) sont des transistors à haute mobilité électronique (HEMT), ladite bande d'hétérojonction étant formée d'une première couche semi-conductrice (612, 704) en particulier à base d'AIGaN empilée sur une deuxième couche semi-conductrice (611, 702), en particulier en GaN.

9. Dispositif électronique de puissance comprenant un convertisseur, doté d'une pluralité de cellules (130, 140, 150) de commutation, chaque cellule de commutation étant pourvue d'un circuit de commutation (C₁₀) selon l'une des revendications 1 à 8.
